# EUROPEAN PATENT SPECIFICATION

(11) **EP 0 318 094 B1**
(45) Date of publication and mention of the grant of the patent: **15.09.1993**
(21) Application number: 88202609.9
(22) Date of filing: 21.11.1988
(51) Int. Cl.: G11C 5/14, H02M 3/07

(54) **Integrated memory circuit with on-chip supply voltage control**
Integrierte Speicherschaltung mit innerer Speisespannungsregelung
Circuit de mémorisation intégré à réglage interne de la tension d'alimentation

(30) Priority: 23.11.1987 NL 8702800
(43) Date of publication of application: 31.05.1989
(73) Proprietor: Philips Electronics N.V., 5621 BA Eindhoven (NL)
(72) Inventor: Pfennings, Leonardus Chritien Matheus Giellaumes, NL-5656 AA Eindhoven (NL); Voss, Peter Hermann, NL-5656 AA Eindhoven (NL); O'Connell, Cormac Michael, NL-5656 AA Eindhoven (NL); Phelan, Cathal Gerard, NL-5656 AA Eindhoven (NL); Davies, Thomas James, 5656 AA Eindhoven (NL); Ontrop, Hans, 5656 AA Eindhoven (NL)
(74) Representative: Strijland, Wilfred

(56) References cited:
- EP-A- 0 063 483
- US-A- 4 691 304
- PATENT ABSTRACTS OF JAPAN, Band 11, Nr. 55 (E-481)[2502], 20. Februar 1987; & JP-A-61 214 772

## Description

The invention relates to an integrated static memory circuit, comprising an external and an internal power supply junction point and a voltage converter which is connected between said junction points in order to apply a voltage to the internal power supply point which is lower than the voltage applied to the external power supply junction point, the memory circuit comprising a matrix of memory cells which are arranged in rows and columns and which are connected to the internal supply voltage, each memory cell in a column being connected to a bit line via an access transistor and applying, if it stores a logic "1", said internal supply voltage to said access transistor, the gates of the access transistors in each row being connected to a word line.

An integrated memory circuit of the kind set forth is known from EP-A-0 063 483 and from IEEE International Solid-State Circuit Conference, February 17, 1987, Session XIX: High density SRAMs; A 256K SRAM with On-chip Power Supply Conversion, pages 252-253. The integrated circuit known from the above publications comprises a voltage converter for converting the voltage applied to the external power supply junction point into a lower voltage which is applied to the memory circuit via the internal power supply junction point. A voltage converter of this kind is necessary in order to protect the transistors of the memory circuit, for example in the memory cells, against so-called hot-electron effects which occur in transistors in the sub-micron range if the normal 5-V standard supply voltage is applied to such circuits comprising such transistors. Even though the use of the lower supply voltage prevents the occurrence of hot-electron effects in the sub-micron transistors, the lower supply voltage has the drawback that the memory cell itself becomes slower, which is an undesirable effect; this effect can be compensated for by making the transistors in the cell slightly wider.

It is the object of the invention to provide a memory circuit of the kind set forth in which the lower internal supply voltage is effectively utilized in order to enhance the reliability and also to achieve fast access to the memory circuit.

To achieve this, the integrated memory circuit in accordance with the invention is characterized in that reading is initiated by precharging the bit lines to for second internal supply voltage being the internal supply voltage minus a threshold voltage of the access transistor connecting the memory cell to the bit line, and applying the internal supply voltage to the selected word line. The above step for the memory in accordance with the invention implies that a maximum noise margin is maintained for the memory cells and the logic high level in a memory cell cannot be disturbed during a read cycle by excessively low voltage on the bit line.

A preferred embodiment of the integrated memory circuit in accordance with the invention is characterized in that the transistors which are controlled by a column selection circuit for selectively connecting a bit line and a non-bit line to a local read bus are switched on by means of selection signals having the level of the external power supply point. Such turning on of the column selection transistors by means of the selection signals whose amplitude equals the external supply voltage offers the advantage that, in the case of a sudden voltage drop on the external or the internal supply line, the column selection transistors still remain fully turned on, so that loss of signal is avoided.

Embodiments in accordance with the invention will be described in detail hereinafter with reference to the accompanying drawing; therein:
Figure 1 shows a part of the integrated memory circuit in accordance with the invention;
Figures 2a and 2b show voltage/time diagrams of various signals occurring in the circuit shown in Figure 1;
Figure 3 shows a circuit for generating interal supply voltages;
Figure 4 is a more detailed representation of a supply voltage control circuit for a memory circuit in accordance with the invention;
Figures 5, 6 and 7 are detailed representations of voltage controllers for the control circuit shown in Figure 4, and
Figure 8 shows a voltage/time diagram of various signals occurring in the voltage controller shown in Figure 7.

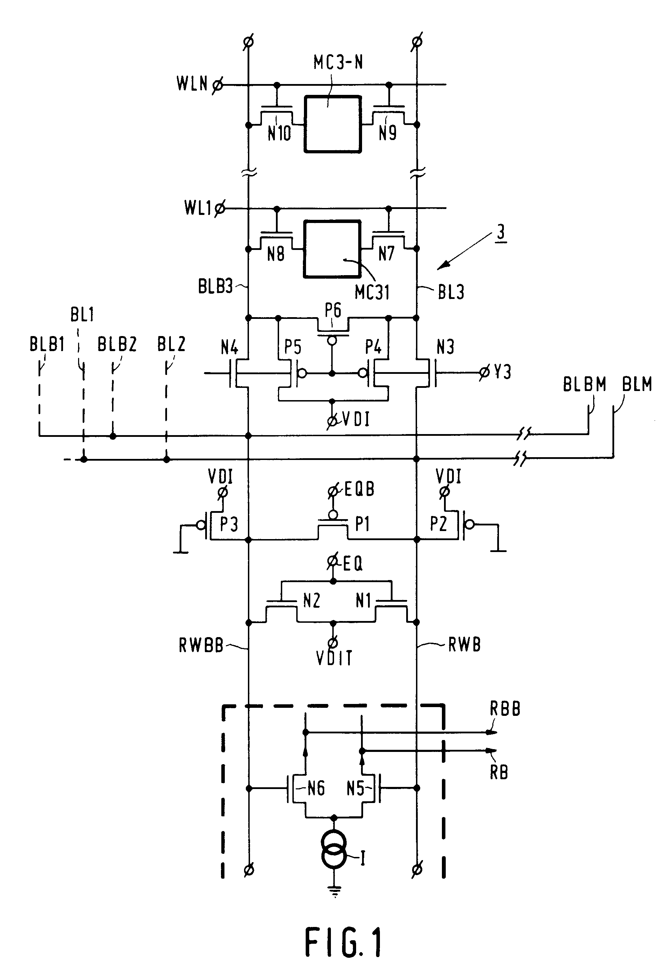

Figure 1 shows a part of an integrated memory circuit in accordance with the invention. Such a memory circuit comprises a matrix of memory cells which are arranged in rows and columns. Figure 1 shows only one column 3 of the memory circuit; only two cells MC3-1 and MC3-N of the entire column 3 are shown. A first memory cell MC3-1 is connected to the word line WL1, and N^{th} memory cell MC3-N shown in the Figure being connected to WLN. Using the word line WL1 or WLN, the memory cell MC3-1 or MC3-N can be connected, via access transistors N7, N8 and N9, N10, respectively, to the bit line BL3 and the complementary or so called non-bit line BLB3. The bit line BL3 and the non-bit line BLB3 are to be connected, via selection transistors N2 and N4, to a local read-write line RWB and a local non-read/write line RWBB. The transistors N3 and N4 are controlled by a selection signal applied to the column selection line Y3. The column selection signal on the column selection line Y3 also serves for the precharge and equalize transistors P4, P5 and P6 as will be described hereinafter. Using these precharge and equalize transistors, the bit line pair BL3 and BLB3 can be precharged to the same potential, i.e. the internal supply voltage VDI applied to the sources of the PMOS transistors P4 and P5. In addition to the bit line pair BL3 and BLB3, further bit line pairs can be connected to the local read/write bus RWB and RWBB as is shown in the Figure for the bit line pairs BL1, BLB1; BL2, BLB2 to BLM, BLBM. The local read/write bus is connected to a local read amplifier which comprises the NMOS transistors N5 and N6 whose sources are connected to a d.c. source I. To the local read/write bus RWB and RWBB there is also connected a discharge and equalize circuit which comprises two NMOS transistors N1 and N2 and one PMOS transistor P1. The transistors N1 and N2 are connected on the one side to the lines of the local read/write bus RWB and RWBB and on the other side to an internal bit line discharge voltage VDIT. The two NMOS transistors N1 and N2 are controlled by an equalize signal EQ whose value at the most equals the supply voltage VDD to be applied from the environment. The equalizer transistor P1 connected between the read/write line RWB and the non-read/write line RWBB is controlled by means of a signal EQB which is the inverse of the signal EQ. The local read/write bus RWB and RWBB is also connected, via a load, to the internal supply voltage VDI, which load is formed by two PMOS transistors P2 and P3 whose gate electrodes are connected to ground in the present case.

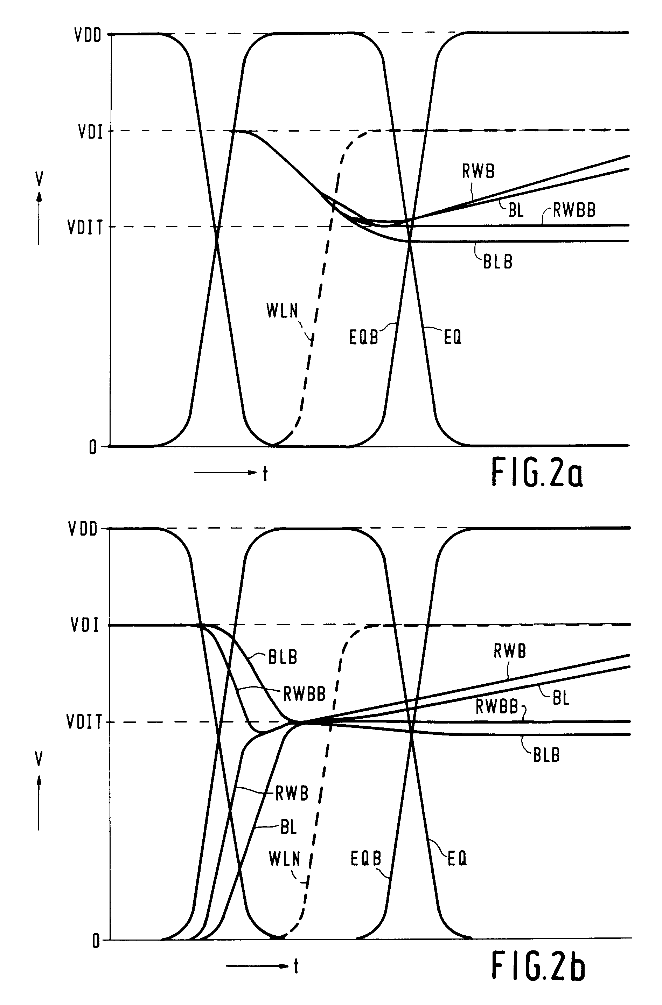

The operation of the sub-circuit shown in Figure 1 will be described with reference to Figures 2a and 2b. In Figure 2a three voltage levels are plotted along the vertical column, i.e. VDD, VDI and VDIT, respectively, the voltage VDD being the externally applied supply voltage standardized to 5 V. The internally generated supply voltage for the matrix of memory cells is VDI and amounts to approximately 3.5 V. The third voltage VDIT is referred to as the bit line discharge voltage and its absolute value is approximately one threshold voltage VTH lower than the internal supply voltage VDI, the threshold voltage VTH being equal to the threshold voltage of the access transistor N7, N8, N9, N10 which connect a memory cell to the memory line BL3 and the non-bit line BLB3. The use of an internal supply voltage VDI which is lower than the external supply voltage VDD enables driving of the selection transistors N3 and N4, serving to select the column 3 to be connected to a local read/write bus RWB and RWBB, by means of column selection signals whose maximum amplitude is VDD. Because the signals to be transferred from the bit line BL3 and the non-bit line BLB3 to the local read bus RWB and RWBB are always below the maximum voltage value VDI, the transistors N3 and N4 will always be fully conductive so that no signal voltage loss occurs thereacross. Furthermore, any voltage fluctuations of the supply voltage will not have an effect on the transfer of signals by the transistors N4 and N3. An additional advantage consists in that these selection transistors are driven by means of a voltage VDD which is substantially higher than the internal supply voltage VDI, so that it is now the use of only a single NMOS selection transistor N3 or N4 in the bit line suffices instead of the customary transfer gate consisting of a parallel connection of a PMOS transistor and an NMOS transistor. The fact the PMOS transistors are superfluous enables a compact layout. An additional advantage consists in that at the location of the PMOS transistors previously used for the transfer gate there can now be arranged PMOS transistors for the precharge of the bit line pair BL3 and BLB3.

In the case of a read operation, the part of the memory circuit in accordance with the invention as shown in Figure 1 operates as follows. In the steady state, the bit line BL3 and the non-bit line BLB3 are charged, like the read/write bus RWB and RWBB, to the internal supply voltage VDI. When the column 3 is selected by the selection signal on the column selection line Y3, the precharge and equalize transistors P4, P5 and P6 are switched off and the selection transistors N3 and N4 are switched on so that the bit line BL3 and the non-bit line BLB3 are connected to the read/write line RWB and the non-read/write line RWBB, respectively. When the signal equalize EQ is switched on, the PMOS transistor P1 and the NMOS transistors N1 and N2 are switched on, with the result that the bit line BL3, the read/write line RWB, the non-bit line BLB3 and the non-read/write line RWBB are discharged to the voltage VDIT via the discharge transistors N1 and N2. Subsequently, the cell MC3-N in the column 3 is selected by means of a word selection signal on the word line WLN, after which the data signals can develop on the bit line BL3 and the non-bit line BLB3. The signal EQ is switched off and the signal EQB is switched on, with the result that the discharge transistors N1 and N2 and the equalize transistor P1 are blocked. Assuming that the information in the memory cell MC3-N in the column 3 will cause a high signal on the bit line BL3 and a low signal on the non-bit line BLB3, the potential will rise on the read/write line RWB under the influence of the PMOS transistor P3 and also on the bit line BL3. The potential on the non-bit line BLB and on the non-read/write line RWBB is kept substantially constant by suitable proportioning of the transistors P3, N10 and the NMOS transistor in the selected memory cell. The read amplifier which is connected to the local read/write bus RWB and RWBB and which comprises the transistors N5 and N6 will detect the difference between the voltages on the read line RWB and the non-read line RWBB and will supply data signals on the data bus RB and RBB of the general read bus, which data signals are in conformity with the information stored in the selected memory cell MC3-N.

Figure 2b shows how the various voltages vary as a function of time at several points of the circuit shown in Figure 1 when a read cycle is performed after a write cycle. During a write cycle the selection transistors N3 and N4 become conductive via a selection signal on the column selection line Y3; in the column 3 shown a desired cell is selected, i.e. in this case the cell MC3-N, which is connected to the non-bit line BLB3 and the bit line BL3 via a selection signal on the access transistors N9 and N10. During the write cycle the signal EQB on the gate electrode of the equalize transistor P1 is high and the signal EQ on the gate electrodes of the discharge transistors N1 and N2 is low, so that the data signals forced onto the local read bus comprising the lines RWB and RWBB by a buffer (not shown) are not disturbed. It is assumed that the signal on the local read/write line RWB is low and that on the local non-read/write line RWBB is high; these signals will be transferred accordingly on the bit line BL3 and the non-bit line BLB3 via the transistors N3 and N4. When a read cycle is executed briefly after this write cycle as shown in Figure 2b, first the equalize signal EQB is made low and at the same time the equalize signal EQ is made high, so that the local read/write bus RWB and RWBB and the bit line pair BL3 and BLB3 assume the level VDIT, the row selection signal WLN still being low. As soon as the local read bus RWB and RWBB and the bit line BL3 and BLB3 have been raised to the desired level VDIT, the row selection signal WLN is made high so that the desired memory cell in the selected column is connected to the bit lines. The data in the memory cell will then start to influence the potentials on the bit line BL3 and BLB3. The equalize signal EQ is then immediately switched off and the non-equalize signal EQB is switched on so that the transistors N1 and N2 and the PMOS transistor P1 are switched off. The signals on the bit line BL3 and the non-bit line BLB3 and on the local read bus RWB and RWBB will then develop as already illustrated in Figure 2a and will be detected by the read amplifier comprising the NMOS transistors N5 and N6.

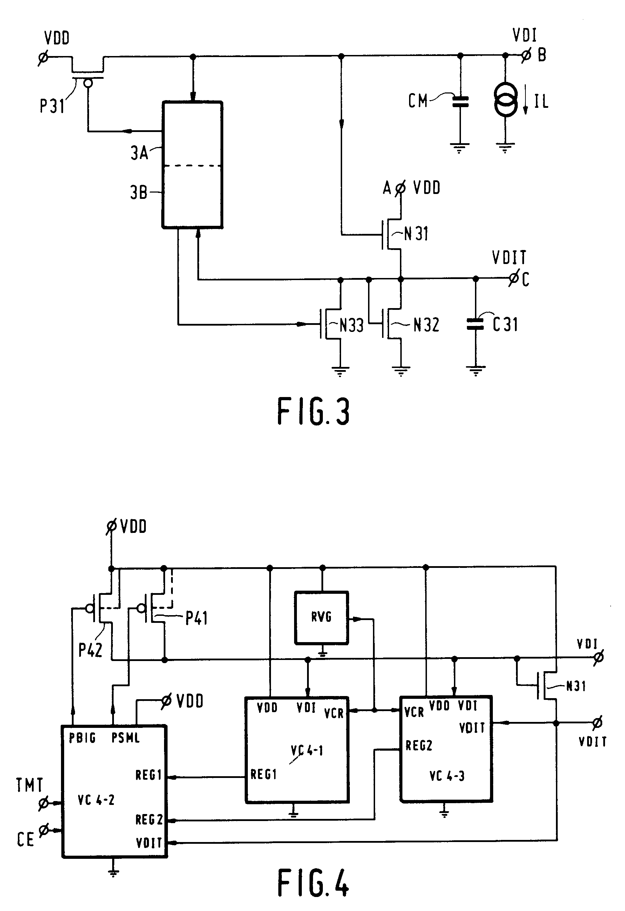

Figure 3 shows a power supply circuit for generating the internal supply voltages VDI and VDIT to be used, which voltages are derived from the supply voltage VDD which is obtained from the environment and which is standardized to 5 V. In Figure 3 the memory matrix of the memory cells and the peripheral circuits connected thereto are represented by a capacitance CM and a current source IL which represent the capacitive load of the power supply circuit and the d.c. dissipating load, respectively. The intensity of the current source IL can vary in practice from some microamperes, when the memory matrix and the peripheral circuits are kept in the stand-by mode, to some tens of milliamperes when the memory circuits and the peripheral circuits have been activated by selection of the memory circuit by chip enable and read/write signals CE and R/W. The power supply circuit shown in Figure 3 comprises, generally speaking, a detection and control circuit which comprises two sections 3A and 3B and a PMOS transistor P31 which is controlled by the sub-circuit 3A in order to generate the internal supply voltage VDI on the output B of the power supply circuit. The PMOS transistor P3 is switched on or off in dependence of the voltage detected on the output B by the sub-circuit 3A. The capacitance CM is thus used as a buffer capacitance. The voltage variation on the terminal B will be + or -100 mV so that, briefly speaking, the circuit 3A switches on the PMOS transistor P31 as soon as the voltage on the terminal B drops below a desired potential, so that the capacitance CM is charged until a desired maximum potential is reached on the terminal B; this is detected by the sub-circuit 3A and the PMOS transistor is switched off. This has already been described in the previously filed (non-published) Netherlands Patent Application No. 8701472 in the name of Applicant (PHN 12. 161). When the voltage across the buffer capacitance CM has reached a desired maximum value and the PMOS transistor P31 has been switched off, the buffer capacitance CM will be discharged via the current source IL. Discharging is allowed to a given value, after which the PMOS transistor P1 is switched on again by the controller 3A.

A bit line charge voltage VDIT is derived from the internal supply voltage VDI, which bit line charge voltage is applied to the terminal C of the circuit shown in Figure 3. The bit line charge voltage VDIT equals VDI-VT, where VT is the threshold voltage of the NMOS access transistors whereby the memory cells (see Figure 1) are coupled to the bit line BL and the non-bit line BLB. The bit line charge voltage VDIT is obtained by connecting the drain of an NMOS transistor N31 to the external supply voltage VDD and by connecting its gate to the internal supply voltage VDI, so that the desired voltage VDIT can appear on its source. However, for each read cycle which does not succeed a write cycle the selected bit line BL and non-bit line BLB must be discharged from the voltage VDI to the desired voltage VDIT (see Figure 2a: equalize discharge signal EQ is high). Consequently, the capacitance C31 connected between ground and the VDIT supply line must be comparatively large with respect to the capacitances formed by the bit lines BL and BLB. However, the R-C time constant determined by the capacitance C31 and the load which is connected parallel thereto in the form of an NMOS transistor N32 whose gate and drain are coupled to the terminal C, should also be adapted to the cycle period of the memory. However, when address skewing is used, where the situation occurs in which each time another bit line pair is selected and these bit line pairs must each time be discharged from the potential VDI to the desired potential VDIT, the voltage on the terminal C will rise beyond the limit of the bit line charge voltage VDIT because of the repeated charge distribution between the bit line capacitances on the one side and the capacitance C31 on the other side. In order to avoid this problem there is provided a voltage controller 3B which switches on an NMOS transistor N33 if the voltage on the terminal C becomes too high, which transistor constitutes a discharge path for the capacitance C31.

Figure 4 is a more detailed representation of the power supply control circuit of Figure 3. The controlled PMOS transistor 31 of Figure 3 is now constructed as two PMOS transistors P41 and P42, P41 being a small PMOS transistor which is switched on each time when the memory operates in a stand-by mode. The second PMOS transistor P42 is a comparatively large PMOS transistor which is switched on when the internal supply voltage VDI is too low and the integrated memory circuit is activated with the control signal chip enable CE. The circuit shown in Figure 4 comprises a reference voltage generator RVG which applies a reference voltage VCR to a voltage controller VC4-1, which voltage controller VC4-1 applies a control voltage REG1 to a second voltage controller VC4-2. Using the control voltage REG1 there is generated a control signal PSML for the small PMOS transistor P41. The reference voltage generator RVG is connected between the external supply voltage VDD and ground. The voltage controller VC4-1 not only receives the reference voltage signal VCR but also the external supply voltage VDD and the internal supply voltage VDI. The second voltage controller VC4-2 receives not only the control signal REG1 but also a control signal REG2 and the bit line discharge voltage VDIT as well as two control signals, i.e. the chip enable signal CE and a test signal TMT, and is of course also connected to the supply voltage VDD. The voltage controller VC4-2 generates two control signals: a first control signal PSML which controls the small PMOS transistor P41 and a second control signal PBIG which controls the comparatively large PMOS transistor P42. To the internal supply voltage line VDI there is also connected a third voltage controller VC4-3 which receives the reference voltage VCR and the bit line discharge voltage VDIT. The bit line discharge voltage VDIT is derived from the source of the NMOS transistor N31 whose drain is connected to the external supply voltage VDD and whose gate is connected to the internal supply voltage line VDI. This voltage controller VC4-3 generates the second control signal REG2 which is applied to the second voltage controller VC4-2. The various voltage controllers VC4-1, VC4-2 and VC4-3 and the reference voltage source RVG will be described in detail hereinafter.

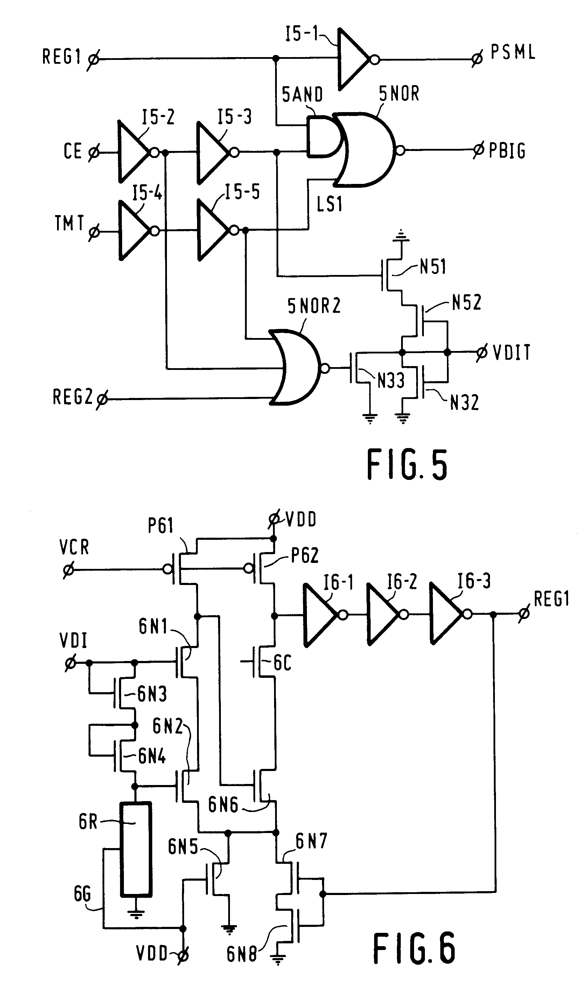

Figure 5 is a detailed representation of the voltage controller VC4-2. The input which receives the control voltage REG1 is connected to a first inverter I5-1 whose output generates the control signal PSML for the small PMOS transistor P41 (see Figure 4). The control signals chip enable CE and the test signal TMT are applied, via a respective pair of inverters I5-2, I5-3 and I5-4, I5-5, to a logic circuit LS1 which comprises an AND-gate 5AND and a NOR-gate 5NOR. The AND-gate 5AND receives the output signal of the inverter I5-3 as well as the control input signal REG1. The output of the AND-gate is connected to an input of the NOR-gate 5NOR which receives the output signal of the inverter I5-5 on a second input. The output signal of the NOR-gate 5NOR is the signal PBIG used to control the large PMOS transistor P42 of Figure 4. The voltage controller VC4-2 shown in Figure 5 comprises a second NOR-gate 5NOR2 which comprises three inputs, a first input receiving a control signal REG2 whilst a second input and a third input receive the output signal of the inverters I5-2 and I5-5, respectively. The output of the NOR-gate 5NOR2 controls the transistor N33 which is shown, like the load transistor N32, in Figure 3. It will be apparent that the junction point of the drain of the transistor N33 and the gate and the drain of the transistor N32 are connected to the output terminal VDIT. Furthermore, via a second load transistor N52 and a further NMOS transistor N51, the output terminal VDI is connected to ground. The latter NMOS transistor N54 is controlled by the output of the inverter I5-3, so essentially by the chip enable signal CE. From the logic circuit shown, comprising the inverters I5-2 to I5-5 and the logic circuit LS1, it can be derived that the PMOS transistor P42 (see Figure 4) is conductive if the test signal TMT is logic high or if the control signal REG1 and the chip enable signal CE are both logic high. The NMOS transistor N33 for discharging the supply line VDI is conductive if the signal REG2 and the signal TMT are both logic low and the chip enable signal CE is logic high.

Figure 6 is a detailed representation of the voltage controller VC4-1. The reference voltage VCR is applied to the gates of two PMOS transistors P61 and P62 which are connected to the external supply voltage VDD on the one side. The PMOS transistor P61 is connected on the other side to two NMOS transistors 6N1 and 6N2 which are connected in series. The gate of the transistor 6N1 receives the internal supply voltage VDI. The second NMOS transistor 6N2 receives a fraction of the internal supply voltage VDI on its gate, which fraction is determined by the series connection of the NMOS transistor 6N3 and 6N4, being connected as a load, and a series connection of further NMOS transistors which act as a resistance and which are represented by a block 6R. The block 6R comprises a series connection of several NMOS transistors whose gate is each time connected to the supply voltage VDD; this is represented in the Figure by a single connection line 6G. The series connection of the transistors 6N1 and 6N2 is connected to ground via a third NMOS transistor 6N5 whose gate is connected to the supply voltage VDD. The junction point between the transistors P61 and 6N1 is connected to the gate of a further NMOS transistor 6N6 whose source is connected to the drain of the transistor 6N5, the drain of the transistor 6N6 being connected, either directly or via a further NMOS transistor 6C, to the drain of the PMOS transistor P62. An intermediate transistor 6C, if any, comprises a gate which is connected to either the external supply voltage VDD or to the reference voltage which is valued slightly below this external supply voltage VDD. Such a transistor 6C is used whenever hot-electron stress is to be avoided across transistors having a channel length in the sub-micron range. The drain of the PMOS transistor P62 is coupled, via three series-connected inverters I6-1, I6-2 and I6-3, to the gates of two further NMOS transistors 6 N7 and 6N8 which are connected in series, which series connection is connected in parallel to the NMOS transistor 6N5. The output of the inverter I6-3 supplies the control voltage REG1 which is applied to the circuit shown in Figure 5. The circuit shown in Figure 6 is actually a Schmitt trigger circuit which is activated when the internal supply voltage VDI drops below a given first threshold and which is deactivated when the internal supply voltage VDI rises beyond a given second threshold. The signal REG1 is logic high when the signal VDI drops below the lower threshold or when the level of the reference signal VCR is too low level with respect to the supply voltage VDD. The input signal on the inverter I6-1 is then logic low, causing a logic high signal on the output REG1.

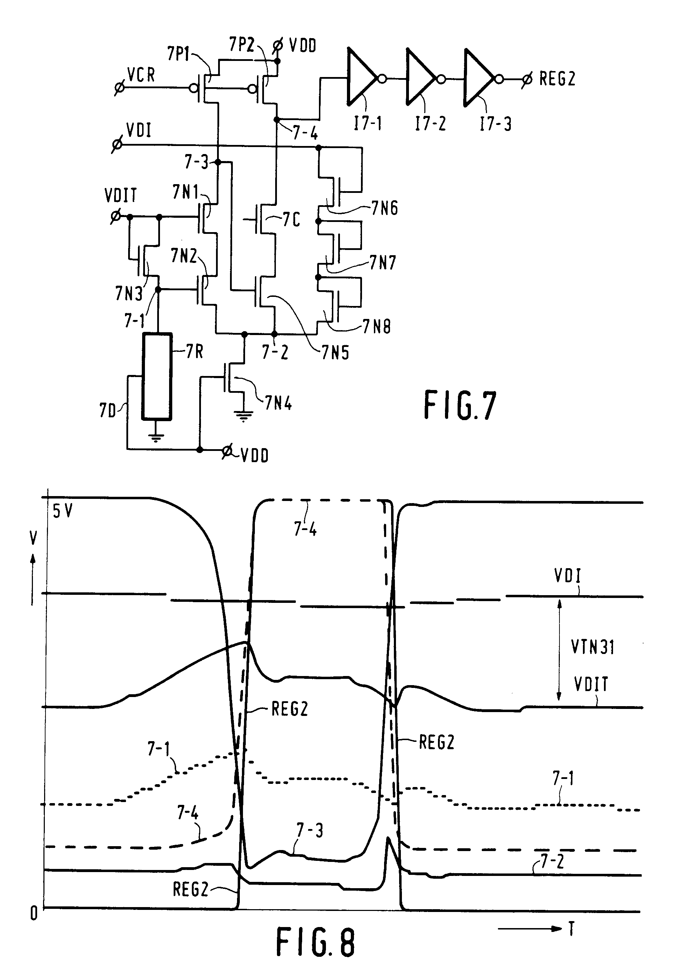

Figure 7 is detailed representation of the voltage controller VC4-3 shown in Figure 4. The voltage VCR generated by the reference voltage generator RVG is applied to two PMOS transistors 7P1 and 7P2 whose sources are connected to the external supply voltage VDD. The drain of the PMOS transistor 7P1 is connected to a series connection of two NMOS transistors 7N1 and 7N2, the transistor 7N1 receiving the discharge voltage VDIT. The gate of the NMOS transistor 7N2 receives a fraction of this bit line discharge voltage VDIT, which fraction is determined by the voltage divider formed by the NMOS transitor 7N3, being connected as a load, and a cascode connection of NMOS transistors which is denoted by the reference 7R. The gates of the NMOS transistors which are connected in cascode in the resistance 7R represented by a block are connected to the supply voltage VDD as denoted by the connection line 7D. The source of the NMOS transistor 7N2 is connected to ground via a further NMOS transistor 7N4. The gate of the NMOS transistor 7N4 is connected to the supply voltage VDD. The drain of the PMOS transistor 7P2 is connected, via a cascode transistor 7C, to the drain of an NMOS transistor 7N5 whose source is connected to the source of the transistor 7N2. The gate of the NMOS transistor 7N5 is connected to the junction point 7-3 of the drain of the PMOS transistor 7P1 and the NMOS transistor 7N1. The transistor 7C shown in Figure 7 has the same function as the cascode transistor 6C shown in Figure 6. Via three transistors 7N6, 7N7 and 7N8, being connected as a load, the internal supply voltage VDI is applied to the junction point 7-2 of the transistors 7N2, 7N4 and 7N5. The junction point 7-4 between the PMOS transistor 7P2 and the cascode transistor 7C is connected to an input of an inverter circuit I7-1 which is connected in series with two further inverters I7-2 and I7-3, the output of the inverter I7-3 supplying the control signal REG2. The control signal REG2 is low if the potential on the junction point 7-4 between the transistors 7P2 and 7C is high. This means that the NMOS transistor 7N5 is not or only hardly conductive. The transistor 7N5 becomes less conductive as soon as the voltage between the points 7-3 and 7-2 becomes too low. This voltage difference between said points decreased if the charge voltage VDIT becomes too high so that the transistors 7N1 and 7N2 become more conductive. The series connection of the NMOS transistors between the input terminal for the internal signal VDI and the ground supplies a bias for the point 7-2 because a coupling must exist between the internal supply voltage VDI and the charge voltage VDIT.

The reference voltage generator RVG shown in Figure 4 comprises a cascode connection of NMOS transistors for generating the reference voltage VCR, the gates of said transistors being connected to the external voltage VDD, the cascode connection being connected in series with PMOS transistors which are connected as a load which between the external supply voltage terminal VDD and the output VCR. It will be apparent that the cascode connection of the NMOS transistors is connected between the output terminal VCR and ground. In order to render the reference voltage on the terminal VCR adjustable, several groups of PMOS transistors, all being connected as a load, can be connected between the supply voltage VDD and the output terminal VCR, this connection being realized via fuses so that the blowing of one or more fuses can deactive one or more PMOS load transistors between the external supply terminal and the output terminal VCR. Similarly, a group of parallel-connected cascodes of NMOS transistors can be connected between the output terminal VCR and ground, one or several parallel-connected cascode connections being connected to the output terminal VCR via fuses. By blowing one or more fuses, one or more cascodes of NMOS transistors can be deactivated. Thus, a comparatively accurately programmable reference voltage generator is realized.

Figure 8 shows various voltages as a function of time which occur in the voltage controller VC4-3 shown in Figure 7. Figure 8 shows the variation of the internal supply voltage VDI which is comparatively constant, and of the bit line discharge voltage VDIT which, as appears from the Figure, in a given situation exhibits a voltage difference amounting to the threshold voltage VTN31 of the transistor N31, shown in Figure 3, with respect to the internal supply voltage VDI. However, because of the repeated selection of bit lines in the read mode, the discharge voltage VDIT is liable to increase in the direction of VDI so that the difference voltage becomes smaller than the threshold voltage VTN31 between the internal supply voltage VDI on the one side and the discharge voltage VDIT on the other side, and can no longer be ensured. Because the discharge voltage VDIT increases, the voltage on the point 7-1 will increase so that the NMOS transistor 7N1 as well as 7N2 (see Figure 7) will become conductive. The potential on the point 7-3 (the drain of the PMOS transistor 7P1) will then drastically decrease from 5 V to less than 1 V. Consequently, the NMOS transistor 7N5 will be blocked. The voltage drop across the transistor 7N4, being the voltage on the junction point 7-2, will also decrease slightly. However, because the transistor 7N5 is not conductive, the voltage on the point 7-4 on the input of the inverter I7-1 will increase. The output of the inverter I7-3 will thus become low so that the control signal REG2 renders the NMOS transistor N33 conductive via the voltage controller VC4-2. Consequently, the capacitance C31 (see Figure 3) will be discharged until the voltage difference between the internal supply voltage VDI and the discharge voltage VDIT is once more approximately equal to the threshold voltage VTN31. At that instant the transistors 7N1 and 7N2 will be blocked again so that the voltage on the point 7-3 (see Figure 7) increases and the transistor 7N5 becomes conductive. As a result, the voltage on the point 7-4 will decrease strongly again so that the NMOS transistor N33 is blocked. The charge voltage VDIT is then again situated at substantially the desired distance VTN31 from the internal supply voltage VDI.

## Claims

1. An integrated static memory circuit, comprising an external and an internal power supply junction point and a voltage converter which is connected between said junction points in order to apply a voltage (V_{DI}) to the internal power supply point which is lower than the voltage (V_{DD}) applied to the external power supply junction point, the memory circuit comprising a matrix of memory cells (MC31..MC3N) which are arranged in rows and columns (3) and which are connected to the internal supply voltage (V_{DI}), each memory cell in a column being connected to a bit line via an access transistor and applying, if it stores a logic "1", said internal supply voltage (V_{DI}) to said access transistor, the gates of the access transistors in each row being connected to a word line (WLN) characterized in that reading is initiated by precharging the bit lines to a second internal supply voltage (V_{DIT}) being the internal supply voltage (V_{DI}) minus a threshold voltage of the access transistor (N7, N8, N9, N10) connecting the memory cell to the bit line, and applying the internal supply voltage (VDN) to the selected word line (WLN).

2. An integrated memory circuit as claimed in Claim 1, characterized in that transistors (N3, N4) which are controlled by a column selection circuit for selectively connecting a bit line (BL3) and a non-bit (BLB3) line to a local read bus (RWB, RWBB) are switched on by selection signals having the level of the external power supply point.

3. An integrated memory circuit as claimed in Claim 1 or 2, characterized in that the integrated memory circuit comprises a circuit for generating said second internal supply voltage (V_{DIT}) which comprises a control transistor (N31) whose gate is connected to the internal supply voltage (V_{DI}) terminal (B) and whose source is connected to a junction point (C) which carries the second supply voltage (V_{DIT}) and to which junction point (C) there is also connected a discharge transistor (N33) whose gate is connected to a control output of a voltage controller (3A,3B), a first and a second input of which voltage controller are connected to the internal supply voltage (V_{DI}) point (B) and the junction point (C) between the control transistor (N31) and the discharge transistor (N33), respectively, the voltage controller (3B) rendering the discharge transistor (N33) conductive if the voltage difference between the internal supply voltage terminal (B) and said junction point (C) is substantially smaller than the threshold voltage of the access transistor (N7, N8, N9, N10) of the memory cells (MC31..MC3N).

4. An integrated memory circuit as claimed in Claim 3, characterized in that a transistor (N32), being connected as a load, and a capacitance (C31) are connected parallel to the discharge transistor (N33), the capacitance value of the capacitance (C31) being substantially larger than that of the parasitic capacitance of a bit line pair (BL3, BLB3).

5. An integrated memory circuit as claimed in Claim 4, characterized in that a series connection of a further load transistor (N52) and a transistor switch (N51) are connected parallel to the discharge transistor (N32), which transistor switch (N51) is switched on by a switch enable signal on the chip enable input (CE) of the integrated memory circuit.

## Patentansprüche

1. Integrierte statische Speicherschaltung mit einem äußeren und einem inneren Speiseknotenpunkt und einem zwischen den genannten Knotenpunkten vorgesehenen Spannungswandler zum dem inneren Speiseknotenpunkt Zuführen einer Spannung (V_{DI}), die niedriger ist als die dem äußeren Speiseknotenpunkt zugeführte Spannung (V_{DD}), wobei die Speicherschaltung eine Matrix reihen- und spaltenweise (3) gegliederter und an die innere Speisespannung (V_{DI}) angeschlossener Speicherzellen (MC31...MC3N) aufweist, wobei jede Speicherzelle in einer Spalte über einen Zugriffstransistor an eine Bitleitung angeschlossen ist und wenn diese Zelle eine logische "1" enthält, die genannte innere Speisespannung (V_{DI}) dem genannten Zugriffstransistor zuführt, wobei die Gate-Elektroden der Zugriffstransistoren in jeder Reihe mit einer Wortleitung (WLN) verbunden sind, dadurch gekennzeichnet, daß das Auslesen dadurch in Gang gesetzt wird, daß die Bitleitungen auf eine zweite innere Speisespannung (V_{DIT}) vorgeladen werden, d.h. die innere Speisespannung (V_{DI}) weniger einer Schwellenspannung des Zugriffstransistors (N7, N8, N9, N10), der die Speicherzelle mit der Bitleitung verbindet, und daß die innere Speisespannung (V_{DI)} der selektierten Wortleitung (WLN) zugeführt wird.

2. Integrierte Speicherschaltung nach Anspruch 1, dadurch gekennzeichnet, daß durch eine Spaltenselektionsschaltung gesteuerte Transistoren (N3, N4) zum selektiven Verbinden einer Bitleitung (BL3) und einer Nicht-Bitleitung (BLB3) mit einer örtlichen Leseleitung (RWB, RWBB) durch Selektionssignale mit dem Pegel des äußeren Speisepunktes eingeschaltet werden.

3. Integrierte Speicherschaltung nach Anspruch 1 oder 2, dadurch gekennzeichnet, daß die integrierte Speicherschaltung eine Schaltungsanordnung zum Erzeugen der genannten zweiten inneren Speisespannung (V_{DIT}), die einen Regeltransistor (N31) aufweist, dessen Gate mit der Klemme (B) der inneren Speisespannung (V_{DI}) verbunden ist und dessen Source mit einem Verbindungspunkt (C) verbunden ist, der die zweite Speisespannung (V_{DIT}) aufweist, und wobei mit diesem Verbindungspunkt (c) ebenfalls ein Entladetransistor (N33) verbunden ist, dessen Gate mit einem Steuerausgang eines Spannungsreglers (3A, 3B) verbunden ist, wobei ein erster und ein zweiter Eingang dieses Spannungsreglers mit dem Punkt (B) der inneren Speisespannung (V_{DI}) bzw. dem Verbindungspunkt (C) zwischen dem Steuertransistor (N31) und dem Entladetransistor (N33) verbunden ist, wobei der Spannungsregler (3B) dafür sorgt, daß der Entladetransistor (N33) nach wie vor leitend ist, wenn die Spannungsdifferenz zwischen der inneren Speisespannungsklemme (B) und dem genannten Verbindungspunkt (C) nahezu kleiner ist als die Schwellenspannung des Zugriffstransistors (N7, N8, N9, N10) der Speicherzellen (MC31...MC3N).

4. Integrierte Speicherschaltung nach Anspruch 3, dadurch gekennzeichnet, daß ein als Last geschalteter Transistor (N32) und eine Kapazität (C31) parallel zu dem Entladetransistor (N33) geschaltet sind, wobei der Kapazitätswert der Kapazität (C31) wesentlich größer ist als der der Streukapazität eines Bitleitungspaars (BL3, BLB3).

5. Integrierte Speicherschaltung nach Anspruch 4, dadurch gekennzeichnet, daß eine Reihenschaltung aus einem weiteren Lasttransistor (N52) und einem Transistorschalter (N51) parallel zu dem Entladetransistor (N32) geschaltet ist, wobei dieser Transistorschalter (N51) durch ein Schaltfreigabesignal an einem Chipfreigabeeingang (CE) der integrierten Speicherschaltung eingeschaltet wird.

## Revendications

1. Circuit de mémoire statique intégré, comprenant des points de jonction d'alimentation électrique externe et interne et un convertisseur de tension qui est connecté entre les points de jonction afin d'appliquer, au point d'alimentation électrique interne, une tension (V_{DI}) qui est inférieure à la tension (V_{DD}) appliquée au point de jonction d'alimentation électrique externe, le circuit de mémoire comprenant une matrice de cellules de mémoire (MC31..MC3N) qui sont disposées en rangées et en colonnes et qui sont connectées à la tension d'alimentation interne (V_{DI}), chaque cellule de mémoire dans une colonne étant connectée à une ligne de bit via un transistor d'accès et appliquant, si elle accueille un "1" logique, la tension d'alimentation interne (V_{DI}) au transistor d'accès, les grilles des transistors d'accès dans chaque rangée étant connectées à une ligne de mots (WLN), caractérisé en ce que la lecture est amorcée en préchargeant les lignes de bit jusqu'à une seconde tension d'alimentation interne (V_{DIT}) qui est la tension d'alimentation interne (V_{DI}) moins une tension de seuil du transistor d'accès (N7, N8, N9, N10) connectant la cellule de mémoire à la ligne de bit et appliquant la tension d'alimentation interne (V_{DI}) à la ligne de mot sélectionnée (WLN).

2. Circuit de mémoire intégré suivant la revendication 1, caractérisé en ce que des transistors (N3, N4) qui sont commandés par un circuit de sélection de colonne destiné à connecter sélectivement une ligne de bit (BL3) et une ligne de non-bit (BLB3) à un bus de lecture locale (RWB, RWBB) sont rendus conducteurs par des signaux de sélection ayant le niveau du point d'alimentation électrique externe.

3. Circuit de mémoire intégré suivant la revendication 1 ou 2, caractérisé en ce que le circuit de mémoire intégré comprend un circuit destiné à produire la deuxième tension d'alimentation interne (V_{DIT}) qui comprend un transistor de commande (N31) dont la grille est connectée à la borne de tension d'alimentation interne (V_{DI}) et dont la source est connectée à un point de jonction (C) qui porte la seconde tension d'alimentation (V_{DIT}), un transistor de décharge (N33) étant également connecté à ce point de jonction (C) et sa grille étant connectée à une sortie de commande d'un régulateur de tension (3A, 3B) dont une première et une seconde entrée sont connectées au point (B) de tension d'alimentation interne (V_{DI}) et au point de jonction (C) entre le transistor de commande (N31) et le transistor de décharge (N33) respectivement, le régulateur de tension (3B) rendant le transistor de décharge (N33) conducteur si la différence de tension entre la borne de tension d'alimentation interne (B) et le point de jonction (C) est sensiblement plus petite que la tension de seuil du transistor d'accès (N7, N8, N9, N10) des cellules de mémoire (MC31-MC3N).

4. Circuit de mémoire intégré suivant la revendication 3, caractérisé en ce qu'un transistor (N32), connecté en tant que charge, et une capacité (C31) sont connectés en parallèle au transistor de décharge (N33), la valeur capacitive de la capacité (C31) étant nettement supérieure à celle de la capacité parasite d'une paire de ligne de bit (BL3, BLB3).

5. Circuit de mémoire intégré suivant la revendication 4, caractérisé en ce qu'un montage en série d'un autre transistor de charge (N52) et d'un commutateur à transistor (N51) sont connectés en parallèle au transistor de décharge (N32), ce commutateur à transistor (N51) étant activé par un signal de validation de commutateur sur l'entrée de validation de puce (CE) du circuit de mémoire intégré.
